# FASCICULE DE BREVET EUROPEEN

(11) **EP 3 029 748 B1**
(45) Date de publication et mention de la délivrance du brevet: **27.03.2019**
(21) Numéro de dépôt: 15196573.8
(22) Date de dépôt: 26.11.2015
(51) Int. Cl.: H01L 41/113, A63B 39/00, H02N 2/18

(54) **DISPOSITIF A COQUE DEFORMABLE COMPRENANT UN CIRCUIT INTERNE PIEZOELECTRIQUE**
VORRICHTUNG MIT VERFORMBARER SCHALE, DIE EINEN INTERNEN PIEZOELEKTRISCHEN SCHALTKREIS UMFASST
DEVICE WITH DEFORMABLE SHELL COMPRISING A PIEZOELECTRIC INTERNAL CIRCUIT

(30) Priorité: 01.12.2014 FR 1461701
(43) Date de publication de la demande: 08.06.2016
(73) Titulaire: COMMISSARIAT À L'ÉNERGIE ATOMIQUE ET AUX ÉNERGIES ALTERNATIVES, 75015 Paris (FR)
(72) Inventeur: SAVELLI, Guillaume, 38000 GRENOBLE (FR); CORONEL, Philippe, 38530 BARRAUX (FR)
(74) Mandataire: Cabinet Laurent & Charras

(56) Documents cités:
- EP-A1- 2 364 752
- CN-A- 101 719 736
- US-A1- 2010 090 477
- US-A1- 2011 136 603

## Description

### DOMAINE DE L'INVENTION

L'invention a trait au domaine de la fonctionnalisation de balles et ballons, en particulier les balles et ballons déformables, notamment dans le domaine du sport et/ou de la rééducation physique et/ou de loisir. L'invention trouve particulièrement application dans les balles de tennis.

### ETAT DE LA TECHNIQUE

Dans les sports de balle et de ballon et la rééducation physique à base de tels objets, il est utile de disposer de statistiques qui permettent aux joueurs d'analyser leur jeu et au personnel médical d'évaluer la qualité des exercices pratiqués par les patients. Usuellement, ces statistiques sont collectées manuellement en comptant par exemple le nombre de frappes, rebonds ou autres qu'un joueur ou un patient exerce sur une balle pendant une durée prédéterminée.

Il existe ainsi un intérêt à intégrer dans les balles et les ballons des fonctions électroniques permettant de réaliser automatiquement des statistiques et/ou de convertir et stocker l'énergie mécanique prodiguée à ces objets lors de leur utilisation en énergie électrique.

On connait du document US 2011/136603 une balle de sport comportant une coque déformable délimitant un volume interne sous pression, comme par exemple une balle de tennis, et comportant un élément piézoélectrique disposé sur ou dans la coque déformable pour convertir l'énergie mécanique correspondant à la déformation de la coque en énergie électrique, et un circuit électronique comportant une batterie pour stockage de l'énergie électrique ainsi produite et un circuit de traitement alimenté par la batterie, comme par exemple un accéléromètre, un capteur de pression ou un système GPS.

Les documents CN 101719736 et US 2010/0090477 divulguent un circuit alimenté électriquement par un générateur piézoélectrique, le circuit comprenant, en outre, un capteur et un émetteur.

Ce document est cependant muet sur la manière d'intégrer ces différents composants dans la balle. Or, cette intégration vise généralement plusieurs objectifs qui peuvent être contradictoires.

Tout d'abord, il est recherché un taux de conversion de l'énergie mécanique en énergie électrique élevé car l'énergie électrique peut servir à alimenter des circuits électroniques requérant un niveau élevé d'énergie pour fonctionner.

Ensuite, les composants intégrés dans la balle doivent gêner au minimum son aérodynamique et ses déformations, car il est recherché une balle fonctionnalisée dont les caractéristiques mécaniques sont proches, idéalement identiques, à celles d'une balle classique afin d'être utilisée en lieu et place de celle-ci, notamment dans le domaine sportif dans lequel les balles et les ballons doivent satisfaire des critères très sévères pour être jugés conformes.

Enfin, il est préférable que les composants soient mécaniquement robustes pour faire face à des contraintes mécaniques qui peuvent être élevées en raison des chocs et des accélérations importantes subis par la balle. Les inventeurs ont d'ailleurs noté, dans le cadre d'essais sur différents types de circuit électronique et de connexions électriques intégrés dans une balle de tennis, des casses fréquentes de ces composants.

### EXPOSE DE L'INVENTION

Le but de la présente invention est de proposer un dispositif à coque déformable délimitant un espace interne qui comprend des circuits produisant de l'électricité sous l'effet de déformation de la coque et exploitant ladite production d'électricité à des fins de traitement et/ou de stockage, qui présente un comportement mécanique proche de celui d'un dispositif dépourvu de tels circuits, et dont les circuits sont robustes tout en présentant un taux élevé de conversion de l'énergie mécanique en énergie électrique.

A cet effet, l'invention a pour objet un dispositif comportant une coque déformable délimitant un volume interne comprenant au moins un système piézoélectrique, ledit système comprenant :
- une membrane piézoélectrique souple apte à produire de l'énergie électrique sous l'effet d'une déformation qu'elle subit ;
- une source d'alimentation électrique rechargeable, formée sur un substrat souple ;
- un circuit électronique comprenant :
   ∘ un circuit de conversion connecté à la membrane piézoélectrique pour convertir l'énergie électrique produite par celle-ci en énergie électrique apte à être employée pour la recharge de la source d'alimentation électrique, et connecté à la source d'alimentation électrique pour recharger celle-ci avec l'énergie électrique convertie ;
   ∘ un circuit de traitement pour produire et mémoriser des données en fonction de l'énergie électrique produite par la membrane piézoélectrique, et connecté à la source d'alimentation électrique pour son alimentation électrique ; et
   ∘ un émetteur sans fil connecté au circuit de traitement pour émettre les données mémorisées dans celui-ci et connecté à la source d'alimentation électrique pour son alimentation électrique,
   dispositif dans lequel chaque système piézoélectrique est disposé en totalité sur et/ou dans la coque déformable.

Par « déformable », on entend ici une coque apte à se déformer sous l'effet d'impacts subis par celle-ci au cours d'une utilisation standard de la coque.

En d'autres termes, il n'existe aucun élément compris dans le volume interne, et aucun élément qui traverse la coque déformable. Tous les éléments du système piézoélectrique sont intégrée sur ou dans la coque qui définit les surfaces d'une balle ou d'un ballon, notamment sur la paroi interne de la coque, à l'intérieur de la coque ou sur paroi externe de la coque. Ainsi, l'ajout des éléments du système piézoélectrique n'influence que très marginalement, voir aucunement, la trajectoire et déformation de coque constitutive d'une balle ou d'un ballon. En outre, le poids total du dispositif peut être adapté pour être compris dans une fourchette de poids officiel que doit par exemple respecter une balle ou un ballon, par exemple en diminuant le poids des éléments rajoutés et/ou en modifiant le poids de la coque.

Selon un mode de réalisation de l'invention, le dispositif comporte une ou plusieurs des caractéristiques suivantes :
- le système piézoélectrique est en forme de bande, ladite bande étant solidaire de la paroi externe de la coque déformable ou solidaire de la paroi interne de la coque déformable ou logée dans la coque déformable ;
- la bande est sensiblement homogène en poids selon sa longueur et sa largeur ;
- la bande est fixée sur une bande de maintien collée sur une paroi de la coque déformable, ladite bande de maintien étant décollable ;
- la source d'alimentation électrique et le circuit électronique sont disposés chacun sur la membrane-piézoélectrique ;
- la source d'alimentation électrique et le circuit électronique recouvre sensiblement exactement la membrane-piézoélectrique ;
- l'épaisseur de la source d'alimentation électrique et l'épaisseur du circuit électronique sont sensiblement égales ;
- la membrane piézoélectrique, la source d'alimentation électrique et le circuit électronique sont empilés les uns sur les autres, la source d'alimentation électrique étant agencée entre la membrane piézoélectrique et le circuit électronique ;
- la source d'alimentation électrique est rechargeable, et le circuit électronique comporte un circuit de conversion connecté à la membrane piézoélectrique pour convertir l'énergie électrique produite par celle-ci en énergie électrique apte à être employée pour la recharge de la source d'alimentation électrique, et connecté à la source d'alimentation électrique pour recharger celle-ci avec l'énergie électrique convertie.
- le dispositif comprend plusieurs systèmes piézoélectriques identiques ;
- la coque présente au moins une symétrie, et dans lequel les systèmes piézoélectriques sont distribués dans et/ou sur la coque conformément à la symétrie de celle-ci ;
- l'émetteur sans fil est un émetteur radio fréquence ;
- la coque est une balle de tennis comprenant une coque en caoutchouc, chaque système piézoélectrique étant disposé en totalité sur et/ou dans la coque en caoutchouc.

### BREVE DESCRIPTION DES FIGURES

L'invention sera mieux comprise à la lecture de la description qui va suivre, donnée uniquement à titre d'exemple, et réalisée en relation avec les dessins annexés dans lesquels :
- la figure 1 est une vue schématique en coupe d'une balle de tennis de l'état de la technique ;
- la figure 2 est une vue schématique en coupe d'une demi-coque de balle de tennis intégrant un système piézoélectrique selon l'invention ;
- la figure 3 est une vue schématique en coupe d'une membrane piézoélectrique entrant dans la constitution du système de la figure 2 ;
- la figure 4 est une vue schématique en coupe d'une balle de tennis intégrant deux systèmes piézoélectriques recyclables selon l'invention ;
- les figures 5A à 5C sont des vues schématiques en coupe d'une demi-coque de balle de tennis illustrant l'intégration d'un système piézoélectrique selon un mode de réalisation de l'invention sur la face externe de la demi-coque ;
- les figures 6A à 6C sont des vues schématiques en coupe d'une demi-coque de balle de tennis illustrant l'intégration d'un système piézoélectrique selon un autre mode de réalisation selon l'invention sur la face externe de la demi-coque ;
- les figures 7A à 7E sont des vues schématiques en coupe illustrant l'intégration de systèmes piézoélectriques selon l'invention dans chacune des demi-coques d'une balle de tennis ; et
- les figures 8A à 8C sont des vues schématiques en coupe illustrant des systèmes piézoélectriques selon l'invention dupliqués à l'intérieur, à l'extérieur ou dans les demi-coques d'une balle de tennis.

### DESCRIPTION DETAILLEE DE L'INVENTION

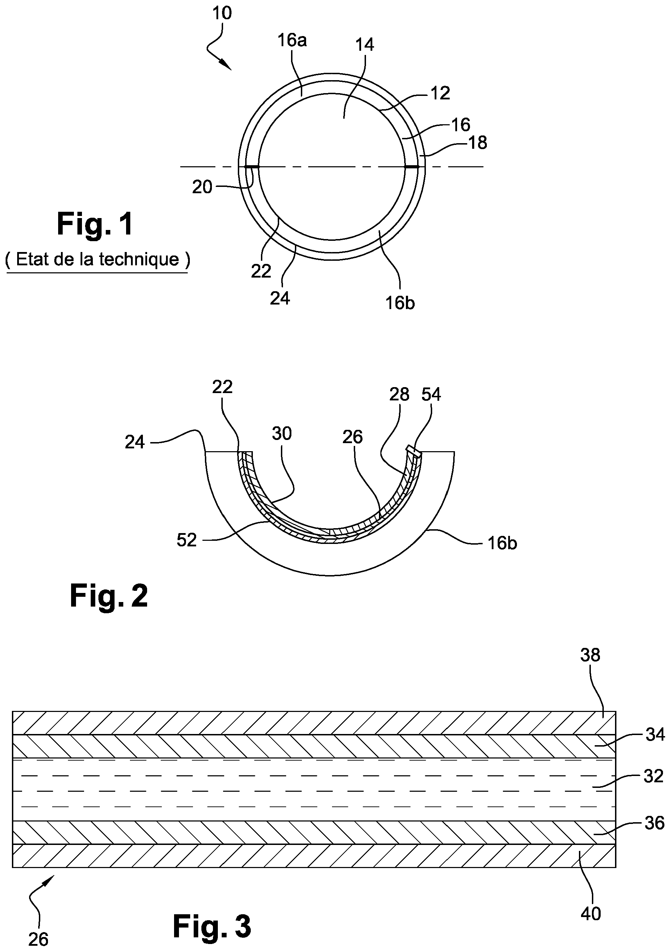

En se référant à la figure 1, une balle de tennis **10** de l'état de la technique comprend une coque sphérique déformable **12** définissant un volume interne creux **14.** La coque **12** est par exemple constituée d'une couche de caoutchouc **16** recouverte d'une couche externe de feutrine **18** et le volume interne **14** comporte de l'air sous une pression supérieure à la pression atmosphérique, notamment une pression de l'ordre de 2 bars. La balle de tennis **10** a un diamètre compris entre 6,5 cm et 6,9 cm, et une masse comprise entre 56 grammes et 59 grammes. Pour la fabrication de la balle **10,** deux demi-coques en caoutchouc sphériques identiques **16a, 16b** sont tout d'abord fabriquées, puis les deux demi-coques **16a, 16b** sont fixées l'une à l'autre au moyen d'une colle **20.** Une fois la colle séchée, la coque **16** est placée dans un tambour rempli de colle pour qu'elle en soit enduite, et la feutrine **18,** découpée au préalable, est ensuite posée sur la paroi externe de la coque en caoutchouc **16.**

Selon l'invention, un ou plusieurs systèmes piézoélectriques pour convertir de l'énergie mécanique en énergie électrique, pour produire et émettre des données statistiques sont intégrés, en totalité, dans la coque **16,** et/ou sur sa paroi interne **22,** et/ou sa paroi externe **24.** En se référant par exemple à la figure 2, un tel système, fixé à la paroi interne d'une des demi-coques de la balle de tennis comporte :
- une membrane piézoélectrique **26** apte à produire une tension sous l'effet de la déformation qu'elle subit, et comportant deux électrodes (non représentées) pour collecter la tension produite ;
- une source d'alimentation électrique rechargeable **28** comprenant deux bornes pour sa recharge et l'alimentation électrique de circuits connectés à celles-ci; et
- un circuit électronique **30** connecté électriquement aux bornes de la membrane piézoélectrique **26** et de la source d'alimentation électrique **28.**

Plus particulièrement, le circuit électronique **30** comprend :
- un circuit de conversion connecté à la membrane piézoélectrique **26** pour convertir la tension produite par celle-ci, par définition variable tant en durée qu'en amplitude, en tension électrique apte à être employée pour la recharge de la source d'alimentation électrique **28.** Notamment, le circuit de conversion comprend un convertisseur AC/DC qui redresse et lisse la tension variable produite par la membrane piézoélectrique **26,** et applique la tension redressée et lissée aux bornes de la source d'alimentation électrique **28** ;
- un circuit de traitement de la tension produite par la membrane piézoélectrique **26,** par exemple à des fins de statistique des frappes subis par la balle de tennis. Le circuit de traitement produit ainsi des données qu'il mémorise dans une mémoire numérique interne. Le circuit de traitement est par ailleurs connecté aux bornes de la source d'alimentation électrique **28** pour son alimentation électrique ; et
- un émetteur sans fil, notamment un émetteur radio-fréquence, connecté aux bornes de la source d'alimentation électrique **28** pour son alimentation électrique. Notamment, l'émetteur est connecté au circuit de traitement pour émettre les données mémorisées dans celui-ci.

En particulier, à chaque fois que la balle subit un choc, par exemple une frappe ou un rebond, la membrane piézoélectrique **28** produit une impulsion de tension correspondante dont l'amplitude et la durée dépendent des caractéristiques du choc. Le circuit de traitement peut par exemple mettre en oeuvre une fonction de comptage du nombre d'impulsions produites depuis la mise en service de la balle de tennis, une fonction de détermination de l'intensité moyenne ou individuelle des impulsions, et/ou une fonction de détermination de la durée moyenne ou individuelle des impulsions. Le circuit de traitement peut comporter d'autre fonctionnalité, comme par exemple un accéléromètre permettant de déterminer la vitesse de la balle.

Notamment, la connaissance du nombre d'impulsions permet de connaître, outre le nombre d'impacts subis par la balle, l'état d'usure de celle-ci, puisque cet état d'usure dépend notamment directement de ce nombre. Le nombre d'impacts, leur intensité et leur durée constituent en outre des données statistiques utiles pour un joueur qui peut ainsi connaître la force de ses frappes et le type de frappes qu'il applique à la balle, etc. Notamment, il a été observé qu'il existe un lien bijectif entre l'amplitude de la première impulsion faisant suite à un impact sur la balle et la force de cet impact. Le circuit de traitement comprend par exemple un abaque mémorisant des valeurs de force en fonction d'amplitude de tension et calcule la force exercée sur la balle en fonction des amplitudes de tensions mémorisées, ou mémorise l'amplitude de l'impulsion, le calcul étant réalisé par un système informatique externe une fois les données d'amplitude émises par l'émetteur radiofréquence et captées par le système informatique qui comprend un récepteur radio fréquence.

L'émetteur radio-fréquence du circuit électronique peut en outre émettre à intervalle régulier et/ou de manière sensiblement continue un signal radiofréquence. Une telle émission permet, une fois le signal reçu et traité par un système de réception, de localiser la balle sur un terrain de tennis, ce qui permet par exemple de savoir si une balle est bonne ou faute.

Avantageusement, les éléments du système piézoélectrique sont choisis pour modifier au minimum l'élasticité de la coque de la balle de tennis et l'aérodynamisme de cette dernière. Notamment, un maximum d'éléments du système sont choisis souples, donc déformables et capables d'épouser les déformations de la balle de tennis.

Plus particulièrement, la membrane piézoélectrique **26** est souple. En se référant à la figure 3, la membrane piézoélectrique **26** comportent par exemple:
- un film piézoélectrique **32,** d'une épaisseur avantageusement comprise entre 10 micromètres et 200 micromètres, réalisé en une seule pièce ou en plusieurs pièces;
- deux couches métalliques **34, 36,** d'une épaisseur de quelques nanomètres à quelques dizaines de micromètres chacune, déposées de part et d'autre du film piézoélectrique **32,** constituées par exemple d'argent, de nitrure de cuivre, d'aluminium, et formant deux électrodes de collecte des charges électriques produites par le film **32** ;
- optionnellement deux couches de renforts flexible **38, 40,** par exemple en plastique, tel que du polyéthylène téréphtalate (« PET ») ou du polyéthylène naphtalate (« PEN »), déposées respectivement sur les électrodes **34, 36.**

Avantageusement, le film piézoélectrique **32** est constitué de polyfluorure de vinylidène (« PVDF ») qui présente l'avantage d'être à la fois léger, souple et mécaniquement résistant. En variante, le film **36** est constitué de titano-zirconate de plomb (« PZT »), d'oxyde de zinc (« ZnO »), ou d'un matériau composite d'au moins deux matériaux parmi ceux-ci et le PVDF. Par exemple, les membranes piézoélectriques sont des « DT sensor » fabriqués par la société Measurement Specialities, Inc.

La source d'alimentation électrique **28** est une micro-pile, une microbatterie, une supercapacité, de préférence réalisée sur un substrat souple. Par exemple, la source micro-batterie à substrat souple de la société Solicore®, Inc.,par exemple un micro-batterie de référence « SF-2529-14EC » d'une surface pliable de 25,75x29 mm² pour une capacité de 14 mAh.

Le circuit électronique **30** est notamment composé d'un microcontrôleur permettant de traiter des informations d'entrées, d'un module autorisant une émission radiofréquence, de capacités de découplage, de capacité et de bobines de filtrage, de convertisseur ADC et de circuit à amplificateur opérationnel (inverseur, soustracteur, etc.).

Le circuit électronique **30** est de préférence également réalisé ou reporté sur un substrat souple. Les fonctions mises en oeuvre par le circuit électronique **30** ne nécessitant pas de grande puissance de calcul et de mémoire informatique importante, un circuit **30** est réalisé par exemple selon la technologie LGA (acronyme de « Land Grid Array ») ou toute technique analogue permettant un taux élevé d'intégration par unité de surface. Il est ainsi obtenu un circuit **30** dont les dimensions et le poids sont très réduits. Par exemple, un émetteur radiofréquence selon cette technologie est un parallélépipède rectangle de surface égale à 5,5x5,5 mm² pour une épaisseur inférieure au millimètre. En variante, le circuit **30** est un circuit également connu sous l'expression de « flex PCB » ou « flex circuit ».

Il est à présent décrit différents mode de réalisation pour l'intégration du système piézoélectrique venant d'être décrit dans et/ou sur la coque **16** de la balle de tennis.

En se référant à nouveau à la figure 2, un premier mode de réalisation consiste à fixer le système venant d'être décrit sur la paroi interne **22** d'une des demi-coques **16b** avant le collage des deux demi-coques **16a, 16b** de la balle de tennis **10.** Plus particulièrement, le système piézoélectrique est conçu sous la forme d'une bande, de préférence d'épaisseur sensiblement constante et/ou de poids sensiblement homogène en fonction de la longueur et de la largeur de la bande et/ou de surface sensiblement égale à celle de la paroi interne **22** de la demi-coque **16b**. A cet effet, la source d'alimentation **28** et le circuit électronique **30** sont par exemples fixés, par exemple par collage, sur la membrane piézoélectrique **26,** cette dernière étant partiellement ou exactement couverte par le circuit électronique et la source d'alimentation.

Dans une variante privilégiée, le système en forme de bande est lui-même collé à une bande de maintien **52,** et la bande de maintien est fixée sur la paroi interne **22** de la demi-coque **16a** avec un adhésif «réversible», c'est-à-dire un adhésif (colle, gel, ...) permettant le détachement de la bande de maintien par un opérateur sans déchirement de la bande. Par exemple, l'adhésif est un scotch double face ou un matériau auto-cicatrisant (également connu sous l'expression anglaise de « self healing »). La bande de maintien **52,** par exemple un scotch double face, permet à la fois une mise en place facile, solide, et également un retrait facile et rapide. De manière privilégié, la bande de maintien comporte une languette **54,** non collée à la demi-coque **16b,** et donc libre d'être attrapée par un opérateur, pour faciliter le détachement de la bande de maintien **52,** et par conséquent du système piézoélectrique. De cette manière, le système peut être recyclé. En effet, l'usure d'une balle de tennis, par exemple, est très rapide, bien plus rapide que la décharge de l'alimentation intégrée dans la balle. Afin de rentabiliser ces balles fonctionnalisées, un système « tout en un » réutilisable est donc proposé.

Les composants du système piézoélectrique sont électriquement reliés entre eux par des fils conducteurs électriques les plus courts et fins possibles. Des éléments comme l'émetteur RF ou/et d'autre composants du circuit électronique et/ou la source d'alimentation peuvent également être déposés et reliés électriquement sur un substrat souple avec des pistes métalliques imprimées directement dessus (PCB avec substrat souple). Dans ce cas, le PCB souple peut également servir directement de bande de maintien et être directement collé directement sur la balle.

Evidemment, l'agencement des éléments entre eux proposé à la figure 3 n'est qu'une possibilité : la répartition et le positionnement précis des éléments technologiques sur l'élément de maintien dépendent de leur masse exacte, de leur nombre (par ex 1 ou 2 µbatteries), de leur surface exacte (dimension de la µbatterie en fonction de sa capacité de charge par ex, etc.), le but étant à la fin d'obtenir une répartition de masse la plus homogène sur la paroi de la balle.

Avantageusement, un deuxième système piézoélectrique, identique à celui venant d'être décrit est fixé à la paroi interne de l'autre demi-coque de la balle de tennis. Ceci permet à la fois une fonction de redondance, la balle de tennis fonctionnalisée continuant de fonctionner si l'un des systèmes est défaillant, et une meilleure répartition du poids, et donc d'avoir une aérodynamique peu modifiée par rapport à une balle de tennis de l'état de la technique.

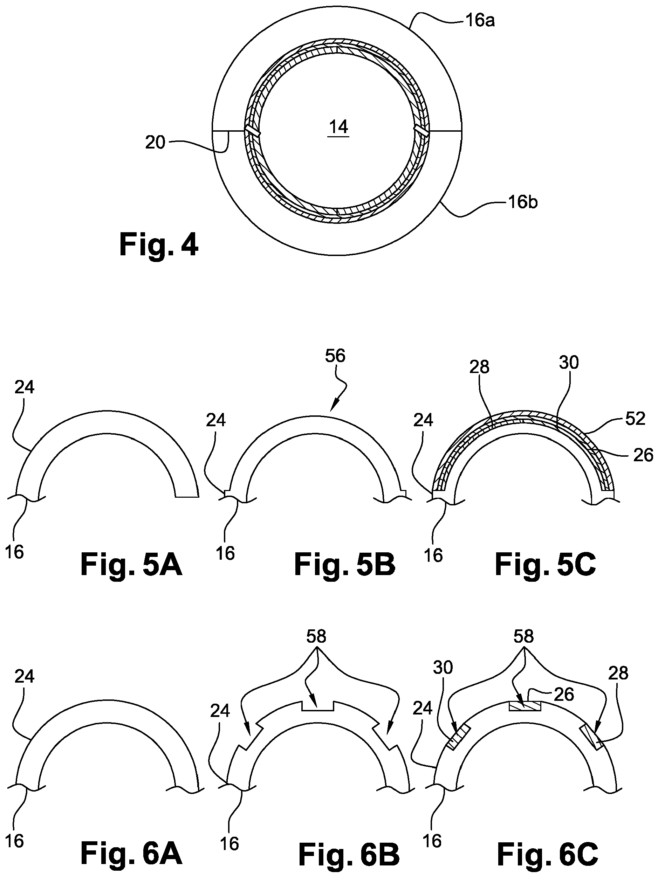

L'intégration des systèmes piézoélectriques selon l'invention est particulièrement aisée, la fabrication d'une balle de tennis selon le premier mode de réalisation consistant en :
1. la réalisation des deux demi-coques en caoutchouc selon la méthode de l'état de la technique ;
2. la mise en place de la bande fonctionnelle contenant un système piézoélectrique sur chaque demi-coque, comme illustré à la figure 2 ;
3. le collage des deux demi-coques en caoutchouc selon la méthode de l'état de la technique, obtenant ainsi une coque fonctionnalisée telle qu'illustrée à la figure 4 ; et
4. la mise en place de la feutrine sur la coque selon la méthode de l'état de la technique.

Le recyclage des systèmes piézoélectriques est également réalisé aisément et consiste par exemple en :
1. la découpe de la balle à l'endroit précis du collage des deux demi-coques, cet endroit étant avantageusement marqué sur la feutrine lors de la fabrication de la balle, par exemple à l'aide d'une encre ;
2. retrait des deux bandes fonctionnelles en tirant les languettes correspondantes ;
3. les deux demi-balles partent au recyclage, par exemple le programme de recyclage mis en place par certaines fédérations de Tennis comme la fédération française ;
4. les deux bandes fonctionnelles sont alors réutilisables, la source d'alimentation étant avantageusement rechargée avant son incorporation dans une nouvelle balle de tennis.

Le mode de réalisation permettant le recyclage induit un coût supplémentaire puisqu'il faut gérer le recyclage des balles. Selon un second mode de réalisation, le ou les systèmes piézoélectriques intégrés dans la balle de tennis ne sont pas recyclables. Outre la réduction de cout, ce mode de réalisation a l'avantage de s'affranchir des bandes de maintien qui ajoute une masse supplémentaire à celle de la balle. S'affranchir de ces bandes permet de relâcher les contraintes en termes de poids de la balle, contraintes particulièrement sévères pour les balles de tennis.

Ce mode de réalisation est identique à celui des figures 2 et 4, à l'exception des éléments de maintien **52, 54** qui sont omis, les systèmes piézoélectriques étant directement collés sur la coque de la balle de tennis.

Pour le premier et le second mode de réalisation, un retrait de masse de caoutchouc, par exemple le retrait d'une épaisseur de la coque en caoutchouc, peut être effectué. Ce retrait peut être réalisé lors de la fabrication des demi-coques ou lors de l'intégration des systèmes piézoélectriques, par exemple par découpe ou brûlage avec un moule. Ceci permet de ne pas modifier la masse totale de la balle par rapport à une balle de l'état de la technique et offre ainsi plus de liberté dans les composants électroniques.

Les deux modes de réalisation concernent une intégration du ou des systèmes piézoélectriques sur la paroi interne **22** de la coque **16** de la balle de tennis.

Selon un troisième mode de réalisation, le ou les systèmes piézoélectriques sont fixés sur la paroi externe **24** de la coque **16** de la balle de tennis. Ce mode de réalisation est similaire aux deux premiers et diffère de ceux-ci par le fait qu'avec ou sans recyclage, l'intégration des bandes fonctionnelles se fait après l'étape de collage des 2 demi-coques en caoutchouc, et avant l'étape de collage de la feutrine. L'ajout de cette dernière permet de protéger mécaniquement les éléments du système piézoélectrique fixés sur la paroi externe de la coque de la balle.

Selon une première variante du troisième mode de réalisation, le ou les systèmes piézoélectriques sont fixés sur la coque en caoutchouc de la balle sans que cette dernière ne subisse de retrait de masse. Selon une deuxième variante du troisième mode de réalisation, illustrée aux figures 5A à 5C, chaque demi-coque (figure 5A) recevant un système piézoélectrique en forme de bande, avec ou sans bande de maintien, subit un retrait de masse sur la paroi externe **24** aux dimensions de la bande fonctionnelle (figure 5B) et la bande est logée dans le retrait ainsi ménagé (figure 5C). Outre le maintien de la masse de la balle selon l'invention dans la gamme de masse exigée pour celle-ci, ceci permet d'aplanir de manière homogène la surface extérieure de la coque afin qu'il n'y ait aucune rugosité apparente due aux ajouts d'éléments sur celle-ci.

Selon une troisième variante, les éléments d'un système piézoélectrique (membrane, alimentation, circuit électronique) sont intégrés indépendamment les uns des autres sur la paroi externe **24** de la coque **16,** comme cela est illustré aux figures 6A à 6C. Cela permet notamment de choisir des éléments d'épaisseur plus élevée mais de surface plus réduite, d'avoir plus de liberté dans le positionnement des éléments les uns par rapport aux autres, dans la manière de répartir les éléments et dans la manière d'homogénéiser la masse de la balle. Les connexions électriques entre les éléments du système est par exemples réalisés à l'aide de câble ou de fils fin et léger, de préférence logés dans des tranchées réalisées dans la coque en caoutchouc **16.** Ces câbles sont de préférence conçus pour absorber les déformations de la balle, les câbles étant par exemple conçus sous la forme de serpentins. Avantageusement, un retrait de masse **58** est réalisé sur la paroi externe **24** de la coque **16** pour chaque éléments (figure 6B) et les éléments sont logés dans leurs retraits respectifs (figure 6C), ce qui évite les rugosités de surface. Bien évidemment, sur les figures 6B et 6C, les retraits et les éléments ont leurs dimensions exagérées à des fins d'illustration, les dimensions de chacun d'entre eux réduite, et inférieures chacune à 10 mm.

Selon un quatrième mode de réalisation, le ou les systèmes piézoélectriques sont intégrés dans la coque **16** de la balle de tennis. L'intégration d'un ou plusieurs systèmes piézoélectrique dans l'épaisseur de la coque en caoutchouc **16** présente l'inconvénient d'être plus délicate à mettre en oeuvre et ne pas permettre un recyclage mais présente l'avantage d'être la solution la plus robuste mécaniquement.

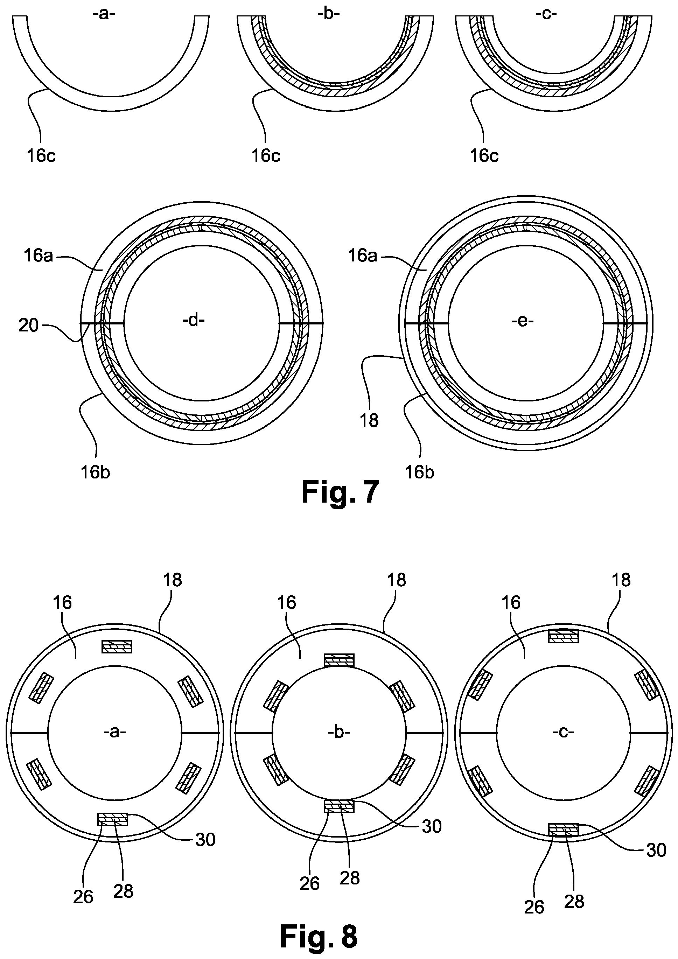

Les figures 7A à 7E illustrent schématiquement un exemple de réalisation du quatrième mode de réalisation. Tout d'abord, les demi-coques en caoutchouc sont réalisées plus minces qu'usuellement (figure 7A). Puis les éléments d'un système piézoélectrique, de surface égale ou non, selon l'équilibre du poids recherché, sont intégrés à la surface des de chaque demi-coques amincies, soit en un seul élément avec un support commun sous la forme d'une bande tel que décrit précédemment (figure 7B), soit individuellement de manière analogue à la figure 6. Une encapsulation de caoutchouc est ensuite réalisée, par exemple soit par collage ou par pressage à chaud, dans la limite de température de tenue des composants technologiques (figure 7C). En variante, le caoutchouc de la balle de tennis est un caoutchouc hybride constitué de caoutchouc naturel ou synthétique auquel est mélangé un matériau à viscosité contrôlable, ce qui permet une encapsulation rigide et la protection mécanique de système piézoélectrique. Les deux demi-coques sont ensuite collées de manière usuelle (figure 7D) et la feutrine est finalement ajoutée de manière usuelle également (figure 7E).

Il a été décrit des formes de réalisation particulière de système piézoélectrique, notamment sous la forme de bande ou d'éléments indépendants. En variante, la membrane piézoélectrique, la source d'alimentation électrique et le circuit électronique sont empilés les uns sur les autres, la source d'alimentation électrique étant agencée entre la membrane piézoélectrique et le circuit électronique.

En outre, les systèmes piézoélectriques peuvent être tous dupliqués une ou plusieurs fois sur les parois ou dans la coque, et ceci pour chacune des quatre modes de réalisation décrits ci-dessus, et tel qu'illustré schématiquement aux figures 8A à 8C pour des systèmes piézoélectriques réalisés sous la forme d'empilement.

De manière optionnelle, un système piézoélectrique comporte une alimentation électrique supplémentaire, par exemple une pile bouton, pour l'alimentation du circuit électronique.

Selon un autre mode de réalisation, la source d'alimentation n'est pas rechargeable, la membrane piézoélectrique produisant un signal électrique sous l'effet de sa déformation mécanique utilisé uniquement à des fins de traitement et/ou de comme déclencheur d'envoi d'informations via l'émetteur sans fil ou de mémorisation dans la mémoire du circuit électronique. Le circuit de conversion est alors avantageusement omis.

Il a été décrit une balle de tennis. Evidemment, l'invention s'applique à tout type de balles et ballon, et de manière générale à tout objet à coque déformable.

Il a été décrit des applications au sport. Evidemment, l'invention s'applique à d'autres types d'activité, notamment les activités de rééducation physique qui utilisent des balles, des ballons, ou autres, les statistiques produites par de tels objets conformes à l'invention permettant au personnel médical d'étudier par exemple la qualité des exercices suivis par les patients.

## Revendications

1. Dispositif comportant une coque déformable (16) délimitant un volume interne (14), comprenant au moins un système piézoélectrique (26, 28, 30), ledit système comprenant :
- une membrane piézoélectrique (26) souple apte à produire de l'énergie électrique sous l'effet d'une déformation qu'elle subit ;
- une source d'alimentation électrique (28), formée sur un substrat souple ;
- un circuit électronique (30) comprenant :
∘ un circuit de traitement pour produire et mémoriser des données en fonction de l'énergie électrique produite par la membrane piézoélectrique, et connecté à la source d'alimentation électrique pour son alimentation électrique ; et
∘ un émetteur sans fil connecté au circuit de traitement pour émettre les données mémorisées dans celui-ci et connecté à la source d'alimentation électrique pour son alimentation électrique,
dispositif dans lequel chaque système piézoélectrique (26, 28, 30) est disposé en totalité sur et/ou dans la coque déformable (16).

2. Dispositif selon la revendication 1, dans lequel le système piézoélectrique (26, 28, 30) est en forme de bande, ladite bande étant solidaire de la paroi externe (24) de la coque déformable (16) ou solidaire de la paroi interne (22) de la coque déformable (16) ou logée dans la coque déformable (16).

3. Dispositif selon la revendication 2, dans lequel la bande est sensiblement homogène en poids selon sa longueur et sa largeur.

4. Dispositif selon la revendication 2 ou 3, dans lequel la bande est fixée sur une bande de maintien (54) collée sur une paroi (22, 24) de la coque déformable, ladite bande de maintien étant décollable.

5. Dispositif selon l'une des revendications 2 à 4, dans lequel la source d'alimentation électrique (28) et le circuit électronique (30) sont disposés chacun sur la membrane-piézoélectrique (26).

6. Dispositif selon la revendication 5, dans lequel la source d'alimentation électrique (28) et le circuit électronique (30) recouvre sensiblement exactement la membrane-piézoélectrique (26).

7. Dispositif selon la revendication 5 ou 6, dans lequel l'épaisseur de la source d'alimentation électrique (28) et l'épaisseur du circuit électronique (30) sont sensiblement égales.

8. Dispositif selon la revendication 1, dans lequel la membrane piézoélectrique, la source d'alimentation électrique et le circuit électronique sont empilés les uns sur les autres, la source d'alimentation électrique étant agencée entre la membrane piézoélectrique et le circuit électronique.

9. Dispositif selon l'une quelconque des revendications précédentes, comprenant plusieurs systèmes piézoélectriques identiques.

10. Dispositif selon la revendication 9, dans lequel la coque présente au moins une symétrie, et dans lequel les systèmes piézoélectriques sont distribués dans et/ou sur la coque conformément à la symétrie de celle-ci.

11. Dispositif selon l'une quelconque des revendications précédentes, dans lequel la source d'alimentation électrique est rechargeable, et dans lequel le circuit électronique (30) comporte un circuit de conversion connecté à la membrane piézoélectrique pour convertir l'énergie électrique produite par celle-ci en énergie électrique apte à être employée pour la recharge de la source d'alimentation électrique, et connecté à la source d'alimentation électrique pour recharger celle-ci avec l'énergie électrique convertie.

12. Dispositif selon l'une quelconque des revendications précédentes, dans lequel l'émetteur sans fil est un émetteur radiofréquence.

13. Dispositif selon l'une quelconque des revendications précédentes, dans lequel la coque est une balle de tennis comprenant une coque en caoutchouc, chaque système piézoélectrique étant disposé en totalité sur et/ou dans la coque en caoutchouc.

## Patentansprüche

1. Eine Vorrichtung, die eine verformbare Schale (16) umfasst, die ein inneres Volumen (14) begrenzt, das mindestens ein piezoelektrisches System (26, 28, 30) umfasst, wobei das System Folgendes enthält:
- eine flexible piezoelektrische Membran (26), die unter der Wirkung einer Verformung, die sie erfährt, elektrische Energie erzeugen kann; -
- eine Stromquelle (28), die auf einem flexiblen Substrat gebildet ist;
- ein elektronischer Schaltkreis (30), umfassend:
∘ eine Verarbeitungsschaltung zum Erzeugen und Speichern von Daten als Funktion der von der piezoelektrischen Membran erzeugten elektrischen Energie, die zur Stromversorgung an die Stromquelle angeschlossen ist; und
∘ einen drahtlosen Sender, der mit der Verarbeitungsschaltung verbunden ist, um die darin gespeicherten Daten zu übertragen und zur Stromversorgung mit der Stromquelle verbunden ist,
Vorrichtung, in der jedes piezoelektrische System (26, 28, 30) vollständig auf und/ oder in der verformbaren Schale (16) angeordnet ist.

2. Vorrichtung nach Anspruch 1, in der das piezoelektrisches System (26, 28, 30) streifenförmig ist, dieser Streifen ist fest mit der Außenwand (24) der verformbaren Schale (16) verbunden oder fest mit der Innenwand (22) der verformbaren Schale (16) verbunden oder in der verformbaren Schale (16) untergebracht.

3. Vorrichtung nach Anspruch 2, in der das Gewicht in der Länge und der Breite des Streifens im Wesentlichen homogen ist.

4. Vorrichtung nach Anspruch 2 oder 3, in der der Streifen auf einem Haltestreifen (54) befestigt ist, der auf eine Wand (22, 24) der verformbaren Schale geklebt ist, dieser Haltestreifen kann abgenommen werden.

5. Vorrichtung nach irgendeinem der Ansprüche 2 bis 4, bei dem die Stromquelle (28) und der Stromkreis (30) jeweils auf der piezoelektrischen Membran (26) angeordnet sind.

6. Vorrichtung nach Anspruch 5, bei dem die Stromquelle (28) und der Stromkreis (30) die piezoelektrische Membran (26) im Wesentlichen genau bedecken.

7. Vorrichtung nach Anspruch 5 oder 6, bei dem die Dicke der Stromquelle (28) und die Dicke des Stromkreises (30) im Wesentlichen gleich sind.

8. Vorrichtung nach Anspruch 1, in der die piezoelektrisch Membran, die Stromquelle und der Stromkreis übereinander gestapelt sind, die Stromquelle ist dabei zwischen der piezoelektrischen Membran und dem Stromkreis angeordnet.

9. Vorrichtung nach irgendeinem der vorstehenden Ansprüche, umfassend mehrere identische piezoelektrische Systeme.

10. Vorrichtung nach Anspruch 9, in der die Schale mindestens eine Symmetrie aufweist und in der die piezoelektrischen Systeme in und/ oder auf der Schale entsprechend deren Symmetrie verteilt sind.

11. Vorrichtung nach irgendeinem der vorstehenden Ansprüche, bei der die Stromquelle wiederaufladbar ist und bei der der Stromkreis (30) einen Wandlungschaltkreis, verbunden mit der piezoelektrischen Membran, enthält, um die von dieser erzeugten elektrische Energie in elektrische Energie umzuwandeln, die zum Wiederaufladen der Stromquelle verwendet werden kann und verbunden mit der Stromquelle um diese mit der umgewandelten elektrischen Energie wiederaufzuladen.

12. Vorrichtung nach irgendeinem der vorstehenden Ansprüche, bei der der drahtlose Sender ein Funkfrequenzsender ist.

13. Vorrichtung nach irgendeinem der vorstehenden Ansprüche, bei dem die Schale ein Tennisball mit einer Gummischale ist, jedes piezoelektrische System ist vollständig auf und/ oder in der Gummischale angeordnet.

## Claims

1. A device comprising a deformable shell (16) defining an inner space (14), comprising at least one piezoelectric system (26, 28, 30), said system comprising:
- a flexible piezoelectric membrane (26) capable of generating electric energy under the effect of a deformation to which it is submitted;
- an electric power source (28), formed on a flexible substrate;
- an electronic circuit (30) comprising:
▪ a processing circuit for generating and storing data according to the electric energy generated by the piezoelectric membrane, and connected to the electric power source for its electric power supply; and
▪ a wireless transmitter connected to the processing circuit to transmit the data stored therein and connected to the electric power source for its electric power supply,
in which device each piezoelectric system (26, 28, 30) is totally arranged on and/or inside of the deformable shell (16).

2. The device of claim 1, wherein the piezoelectric system (26, 28, 30) is bandshaped, said band being secured to the outer surface (24) of the deformable shell (16) or secured to the inner surface (22) of the deformable shell (16) or housed in the deformable shell (16).

3. The device of claim 2, wherein the band is substantially homogeneous by weight lengthwise and widthwise.

4. The device of claim 2 or 3, wherein the band is fastened to a holding band (54) glued on a wall (22, 24) of the deformable shell, said holding band being detachable.

5. The device of any of claims 2 to 4, wherein the electric power source (28) and the electronic circuit (30) are each arranged on the piezoelectric membrane (26).

6. The device of claim 5, wherein the electric power source (28) and the electronic circuit (30) substantially exactly cover the piezoelectric membrane (26).

7. The device of claim 5 or 6, wherein the thickness of the electric power source (28) and the thickness of the electronic circuit (30) are substantially equal.

8. The device of claim 1, wherein the piezoelectric membrane, the electric power source, and the electronic circuit are stacked on one another, the electric power source being arranged between the piezoelectric membrane and the electronic circuit.

9. The device of any of the foregoing claims, comprising a plurality of identical piezoelectric systems.

10. The device of claim 9, wherein the shell exhibits at least one symmetry, and wherein the piezoelectric systems are distributed inside of and/on the shell in accordance with the symmetry thereof.

11. The device of any of the foregoing claims, wherein the electric power source is rechargeable, and wherein the electronic circuit (30) comprises a conversion circuit connected to the piezoelectric membrane to convert the electric energy generated by said membrane into electric energy capable of being used to recharge the electric power source, and connected to the electric power source to recharge it with the converted electric energy.

12. The device of any of the foregoing claims, wherein the wireless transmitter is a radio frequency transmitter.

13. The device of any of the foregoing claims, wherein the shell is a tennis ball comprising a rubber shell, each piezoelectric system being totally arranged inside of and/or on the rubber shell.
